# EUROPEAN PATENT APPLICATION

(11) **EP 1 455 005 A2**
(43) Date of publication of application: **08.09.2004**
(21) Application number: 04003195.7
(22) Date of filing: 12.02.2004
(51) Int. Cl.: C25D 3/38, C25D 1/04, C25D 3/12, C25D 7/06

(54) **Copper foil for high frequency circuit and method of producing of same**

(30) Priority: 12.02.2003 JP 2003033159
(71) Applicant: FURUKAWA CIRCUIT FOIL CO., LTD., Tokyo 101-0054 (JP)
(72) Inventor: Shinozaki, Kensaku, Imaichi-city Tochigi-ken 321-2336 (JP)
(74) Representative: Schmidt-Evers, Jürgen, Dipl.-Ing.

(57) **Abstract**

An electrodeposited copper foil having a rough surface having knob-like projections and a surface roughness of 2 to 4 µm at part of a surface thereof produced by electrolysis using an electrolyte containing copper as a main component and a compound having mercapto groups, at least one type of another organic compound, and chloride ions and an electrodeposited copper foil obtained by roughening treating an untreated copper foil having a matte side, for bonding with a resin substrate, having knob-like projections and a surface roughness of 2 to 4 µm by running a predetermined current through it for a predetermined time in an electroforming bath.

## Description

### BACKGROUND OF THE INVENTION

### 1. Field of the Invention

The present invention relates to a copper foil having a small surface roughness of the matte side particularly suitable for a conductive material of printed circuits for high frequency applications and a method of production of the copper foil.

While the main use of the present invention is a conductive material of printed circuits for high frequency applications, the electrodeposited copper foil of the present invention is not limited to that use.

### 2. Description of the Related Art

Electrodeposited copper foil used for conductive material for a printed circuit has to give the peel strength, electric characteristic, etching characteristics, heat resistance, etc. required for the surface bonded with a resin substrate (hereinafter called the "matte side"). In order to satisfy these characteristics, various methods of treatment for roughening the matte side and improving its chemical properties have been proposed and put practical in use.

As an example, the method is proposed of performing electrolysis in an acidic copper electroforming bath using the copper foil as the cathode near the limit current density for burnt plating to obtain a rough surface (see for example Japanese Examined Patent Publication (Kokoku) No. 40-15327). Further, the method is proposed of covering the burnt plating surface of the rough surface by smooth copper plating to bind the plurality of the projections stably by the copper foil surface (see for example specification of U.S. Patent No. 3293109).

In recent years, mobile phones and other mobiles have spread rapidly. Along with this, copper foil superior in high frequency characteristics has become demanded for base stations of mobile phones and supercomputers. At a high frequency, the skin effect arises, passage of an alternating current through the conductor results in a change in the magnetic flux and therefore the occurrence of an electromotive force at the center of the conductor and a consequent difficulty in flow in current. The higher the frequency of the alternating current, the more remarkable this phenomenon. The current comes to flow almost all at the skin portion. Due to this, in the high frequency band, the current flows only at the shiny side surface and the matte side surface. Therefore, it has been considered that if the roughness (Rz) of the shiny side and the matte side of the copper foil were large, the transmission distance would become longer and attenuation and delay of the signal or other problem would occur and that copper foil with a low profile is suitable as copper foil for a conductive material of printed circuits for high frequency applications.

However, the inventors engaged in various experiments in order to meet the demands for copper foil superior in high frequency characteristics and as a result obtained different results from the above theory.

Table 1 shows the transmission loss when transmitting a high frequency signal of 3 GHz to copper foils having various surface roughnesses of the matte side. Table 1 demonstrates that the roughness of the matte side has an extremely small influence on the transmission loss.

**Table 1**

| Roughening treating conditions (roughening current divided by roughening speed (A·min/m) | Roughness of untreated foil (µm) | Roughness after roughening treating (µm) | Peel strength (kN/m) | 3 GHz transmission loss (dB/m) |
|---|---|---|---|---|
| 400 | 1.70 | 1.99 | 0.74 | 3.97 |
| 400 | 1.12 | 1.33 | 0.61 | 3.98 |
| 1000 | 1.60 | 3.77 | 1.00 | 4.03 |
| 1000 | 1.20 | 1.72 | 0.74 | 4.01 |
| 300 | 4.74 | 5.14 | 0.92 | 3.92 |

Therefore, the inventors engaged in further study about factors causing transmission loss and as a result found that the strength of the roughening (here, "strength of roughening treating" defined as roughening current divided by roughening speed, that is, A·min/m) for causing deposition of copper particles on the matte side has a large influence.

Namely, in the related art, the roughening treating needed to be strong (roughing current large or roughening time long) to obtain a sufficient peel strength. Doing that made the transmission loss worse.

Therefore, it may be considered to make the roughening treating weak (roughing current small or roughening time short). However, if the roughening treating is made weak, a new problem will occur that a sufficient peel strength will not be obtained. Table 2 shows the result of measurement of the strength of the roughening treating, peel strength, and transmission loss observed for the same untreated copper foil. If the roughening treating is strong, the peel strength becomes improved but the transmission loss is also influenced, while if the roughening treating is weak, the transmission loss becomes improved but the peel strength declines.

**Table 2**

| Roughening treating conditions (roughening current divided by roughening speed (A·min/m) | Roughness of untreated foil (µm) | Roughness after roughening treating (µm) | Peel strength (kN/m) | 3 GHz transmission loss (dB/m) |
|---|---|---|---|---|
| 2600 | 0.83 | 2.30 | 1.07 | 4.38 |
| 2000 | 0.83 | 1.80 | 0.95 | 4.06 |
| 1600 | 0.83 | 1.60 | 0.87 | 4.00 |
| 1300 | 0.83 | 1.25 | 0.80 | 3.83 |

The same trend appears in almost all types of foils. The same applies when using untreated foil having a large roughness of the matte side. That is, it was not possible to realize both a high transmission characteristic and high peel strength even if using untreated foil which has a large roughness of the matte side.

Note that the value of the transmission loss is influenced largely by the measurement environment. In the present specification, the transmission loss was measured under the same environment to compare the measured values. Therefore, the values in Table 1, Table 2, and other values can be compared.

An invention for producing a copper foil using an electrolyte of copper added with a compound having a mercapto group, at least one kind of other organic compounds and chloride ion (see Japanese Patent Publication No. 3313277). The copper foil produced in this invention has a shiny and very smooth surface at the matte side too. By burnt plating or otherwise treating this copper foil, a copper foil that has a matte side having a very low roughness and is suitable for fine patterns can be produced.

Therefore, from conventional theory, it had been considered that if the roughness of the shiny side and the matte side were small, the transmission loss could be improved. Due to this, the foil with shiny side at the two sides obtained by the art disclosed above was expected to give extremely excellent transmission loss characteristics. However, that foil needed strong roughening treating to obtain a peel strength (while roughness of the matte side was small, the roughening treating was strong). As a result, the transmission loss ended up becoming very poor. The reason is the transmission loss is more dependent on the strength of the roughening treating than the surface roughness as shown in experimental results of Table 1 and Table 2.

### SUMMARY OF THE INVENTION

An object of the present invention is to provide electrodeposited copper foil having a high enough peel strength to meet the demands for recent printed circuit boards and an excellent high frequency transmission characteristic and a method of production of the same.

Another object of the present invention is to provide a copper foil having a high peel strength, capable of being applied to a fine pattern-compatible copper foil having small roughness of the matte side, and able to be used to give an excellent printed circuit board with fine patterns improved in high frequency transmission loss.

According to a first aspect of the present invention, there is provided an electrodeposited copper foil wherein part of its surface comprises a rough surface having knob-like projections and a surface roughness of 2 to 4 µm.

Preferably, the rough surface having the knob-like projections and the surface roughness of 2 to 4 µm is a surface of an untreated copper foil for bonding with a resin substrate and is further roughening treated by running a predetermined current through the foil for a predetermined time in an electroforming bath.

More preferably, the electroforming bath is an acidic electroforming bath containing at least one of molybdenum, cobalt, nickel, iron, tungsten and arsenic.

Still more preferably, the rough surface is further formed with a copper plating layer.

Alternatively, the rough surface is further formed with a copper plating layer, at least one layer of nickel plating, zinc plating, cobalt plating, plating of an alloy of the same and a chromate treatment on that, and a coupling agent treatment layer according to need on that.

Preferably, the rough surface having the knob-like projections and the surface roughness of 2 to 4 µm is a surface of an untreated copper foil for bonding with a resin substrate and is further is further formed with a copper plating layer, at least one layer of nickel plating, zinc plating, cobalt plating, plating of an alloy of the same and a chromate treatment on that, and a coupling agent treatment layer according to need on that.

According to a second aspect of the present invention, there is provided a method of producing an electrodeposited copper foil comprising electrolysis using an electrolyte containing copper as a main component and a compound having mercapto groups, at least one type of another organic compound, and chloride ions to form a copper foil wherein part of its surface comprises a rough surface having knob-like projections and a surface roughness of 2 to 4 µm.

Preferably, an electroforming bath for a roughening treatment is an acidic electroforming bath containing at least one of molybdenum, cobalt, nickel, iron, tungsten and arsenic.

According to a third aspect of the present invention, there is a method of producing an electrodeposited copper foil comprising producing an electrodeposited copper foil having a matte side having a surface roughness of 2 to 4 µm using an electrolyte containing a compound having mercapto groups, at least one type of another organic compound, and chloride ions and roughening treating the matte side of the electrodeposited copper foil by running a predetermined current through it for a predetermined time in an electroforming bath.

### BRIEF DESCRIPTION OF THE DRAWINGS

These and other objects and features of the present invention will become clearer from the following description of the preferred embodiments given with reference to the attached drawings, wherein:
FIG. 1 is an electron micrograph of the surface of a copper foil of one example of the present invention;
FIG. 2 is an electron micrograph of the surface of a copper foil of another example of the present invention; and
FIG. 3 is an electron micrograph of the surface of a copper foil of a further example of the present invention.

### DESCRIPTION OF THE PREFERRED EMBODIMENTS

Preferred embodiments of the present invention will be described in detail below while referring to the attached figures.

The electrodeposited copper foil according to the preset embodiment is characterized in that part of its surface is a rough surface having knob-like projections and having a surface roughness of 2 to 4 µm. Such an electrodeposited copper foil is produced by electrolysis using an electrolyte containing a compound having mercapto groups, at least one type of another organic compound, and chloride ions. The thus prepared surface to be bonded to a resin substrate (bonding surface) is finished to a smooth surface of a surface roughness of 2 to 4 µm, has knob-like projections formed on part of the smooth matte side, and can provide copper foil superior in high frequency transmission loss.

However, the above electrodeposited copper foil lacks peel strength. Stronger peel strength is demanded according to the application. In order to satisfy this demand, the electrodeposited copper foil is run through by a predetermined current as untreated copper foil for a predetermined time in an electroforming bath to roughen the matte side. The roughening treating performed on the untreated copper foil is performed under weaker treatment conditions than the conventional roughening treating. Due to the weak roughening treating, an electrodeposited copper foil has a peel strength equal to or stronger than a conventional one (namely, the roughness of the matte side is large but the roughening treating is weak) and is superior in high frequency transmission loss.

As the roughening electroforming bath for the roughening treating, an acidic electroforming bath containing at least one of molybdenum, cobalt, nickel, iron, tungsten, and arsenic can be used. Note that by performing the roughening treated copper foil by at least one of nickel plating, zinc plating, cobalt plating, plating of an alloy of the same, treating it by chromate treatment and a coupling agent treatment, the heat resistance, resistance to HCl, stain proofing, and peel strength can be improved.

Further, by performing the untreated copper foil by at least on of nickel plating, zinc plating, cobalt plating, plating of an alloy of the same, chromate treatment and a coupling agent treatment, a copper foil having a surface roughness smaller than a roughening treated copper foil and having a high peel strength to a certain type of substrate can be produced. Further, by plating and treating by a coupling agent, the heat resistance, resistance to HCl, and stain proofing can be further improved.

Next, production conditions for the electrodeposited copper foil and examples of surface treatment of an untreated copper foil using it as an untreated copper foil will be shown. Note, however, that the present invention is not limited to these examples.

### Example 1

### (1) Electrodeposited Copper Foil-Making Conditions and Solution Composition

Electrodeposited copper foils were produced under the electrolyte composition and the electrolysis conditions shown in A to C of Table 3 (hereinafter, referred as Examples A to C) as the electrodeposited foil-making conditions of the present invention. Further, untreated copper foil was produced under the electrolyte composition and the electrolysis conditions as shown in D of Table 3 as a comparative example.

**Table 3**

| Conditions for producing copper foils and solution compositions | | | | | | | | |
|---|---|---|---|---|---|---|---|---|
| Conditions | Copper (g/l) | Sulfuric acid (g/l) | MPS (ppm) | HEC (ppm) | Glue (ppm) | Cl (ppm) | Current density (A/dm²) | Solution temp. (°C) |
| A | 90 | 80 | 0.8 | 5 | | 40 | 60 | 60 |
| B | 90 | 80 | 1 | 5.5 | | 40 | 60 | 60 |
| C | 90 | 80 | 1 | 4 | 2 | 40 | 60 | 60 |
| D | 90 | 80 | 1 | 3 | 6 | 40 | 60 | 60 |
| MPS: Sodium 3-mercapto propane sulfonate | | | | | | | | |
| HEC: Hydroxyethylcellulose | | | | | | | | |

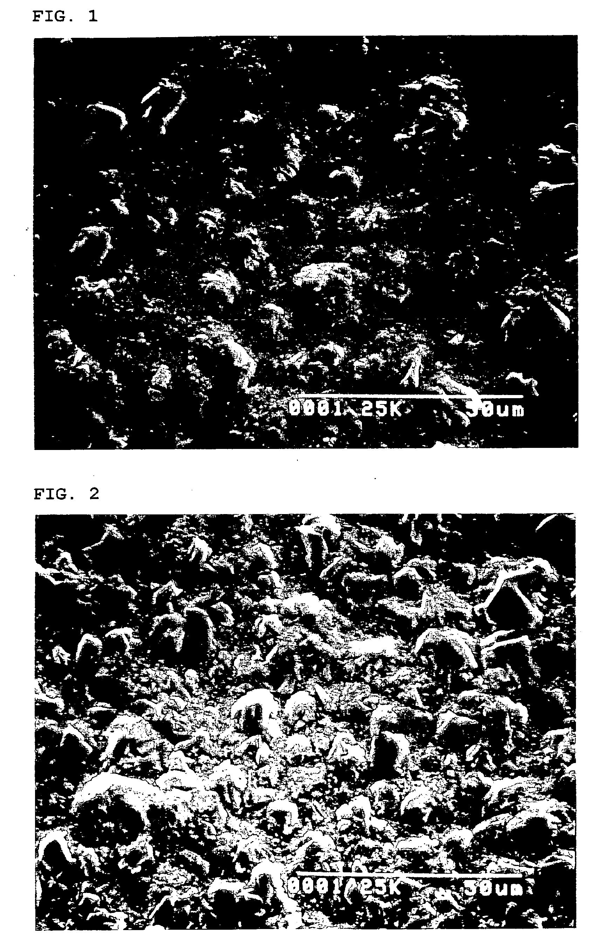

The performances of the produced electrodeposited copper foils are shown in Table 4, while the surface states are shown in the electron micrographs of the surfaces of the copper foils of FIGS. 1 to 3.

**Table 4**

| Performance of copper foils | | | |
|---|---|---|---|
| Conditions | Foil thickness (µm) | Roughness of shiny side (µm) | Roughness of matte side (µm) |
| A | 35 | 1.5 | 3.5 |
| B | 35 | 1.5 | 3.6 |
| C | 35 | 1.5 | 2.4 |
| D | 35 | 1.5 | 0.8 |

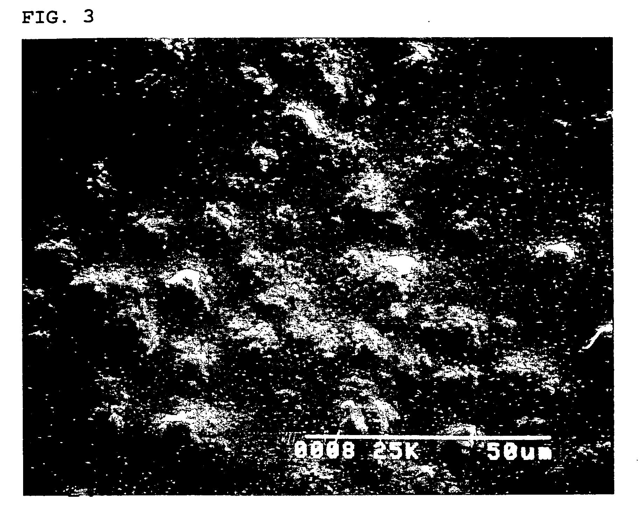

FIG. 1 shows the surface state of foil produced under the foil-making conditions A. The knob-like projections are dispersed evenly. FIG. 2 shows the surface state of foil produced under the foil-making conditions B. The knob-like projections are closely concentrated. FIG. 3 shows the surface state of foil produced under the foil-making conditions C. The knob-like projections are small and dispersed evenly with longer distances between them than in FIG. 1.

### (2) Roughening Treating Conditions and Roughening Solution Composition

The surfaces of the electrodeposited copper foils A to D produced above were roughening treated by the roughening solution composition shown in Table 5.

**Table 5**

| Roughening solution compositions | | | | | | | | |
|---|---|---|---|---|---|---|---|---|
| | Cu (g/l) | Sulfuric acid (g/l) | Mo (ppm) | Ni (g/l) | Fe (g/l) | W (ppm) | As (ppm) | Co (g/l) |
| 1 | 25 | 160 | 350 | | 4.0 | 0.2 | | |
| 2 | 25 | 160 | 50 | | 8.0 | 0.4 | | |
| 3 | 25 | 160 | 250 | 2.0 | | | | |
| 4 | 25 | 160 | 250 | | | | | 2.0 |
| 5 | 25 | 160 | 350 | | 4.0 | | | |
| 6 | 25 | 160 | | | | | 350 | |

The roughening treating was performed under the following conditions:
Roughening current density: 5 to 30 A/dm²
Treatment time: 2 to 15 seconds
Temperature: 20 to 40°C

The roughening current density (5 to 30 A/dm²) is lower than the roughening current density used conventionally. Note that the reason the treatment time is made 2 to 15 seconds is the sizes of the anodes were changed for treatment. The line speed was the same for the solution compositions.

The surface of the roughening treated copper foil was encapsulation plated under the conditions shown in Table 6.

**Table 6**

| Encapsulation plating solution condition | | | | |
|---|---|---|---|---|
| Copper (g/l) | Sulfuric acid (g/l) | Solution temp. (°C) | Current density (A/dm²) | Treatment time (sec) |
| 65 | 100 | 50 | 10 to 60 | 2 to 15 |

The roughening treating and the encapsulation plating treatment may be performed several times in the present invention.

### (3) Performance After Roughening treating (Treatment Under Same Conditions)

The performances of the roughening treated and encapsulation plated copper foils are shown in Table 7.

**Table 7**

| Untreated copper foil | Roughening solution composition | Untreated copper foil Rz | Rz after roughening treating | Peel strength with FR-4 (kN/m) |
|---|---|---|---|---|
| A | 1 | 3.5 | 4.9 | 1.54 |
| A | 2 | 3.5 | 5.2 | 1.53 |
| A | 3 | 3.5 | 6.2 | 1.50 |
| A | 4 | 3.5 | 6.4 | 1.51 |
| A | 5 | 3.5 | 7.1 | 1.62 |
| A | 6 | 3.5 | 7.1 | 1.51 |
| C | 1 | 2.4 | 4.0 | 1.52 |
| C | 2 | 2.4 | 4.2 | 1.50 |
| C | 3 | 2.4 | 5.1 | 1.47 |
| C | 4 | 2.4 | 5.5 | 1.48 |
| C | 5 | 2.4 | 6.0 | 1.60 |
| C | 6 | 2.4 | 6.3 | 1.51 |
| D | 1 | 0.8 | 1.1 | 0.60 |
| D | 6 | 0.8 | 1.3 | 0.54 |

As clear from Table 7, the differences between untreated copper foils, that is, the peel strengths to FR-4 among Examples A and C and Comparative Example D, are extremely different. The present invention gives untreated copper foils having a surface roughness of 2 to 4 µm and knob-like projections on part of the foil surface. The result is remarkable.

Note that the untreated copper foils A and B produced above exhibited almost the same performances as shown in Table 4, so only Example A was roughening treated. The roughening treating for Example B was omitted. Further, by plating the plated surface of the copper foil by one of nickel, zinc, cobalt, or an alloy of the same or treating it by chromate or a coupling agent, the heat resistance, resistance to HCl, stain proofing, and peel strength can be improved.

### (4) Comparison of Transmission Loss and Peel Strength

The foils of Example C and Comparative Example D of the present invention were measured for high frequency transmission loss and peel strength while changing the roughening current divided by roughening speed. The results are shown in Table 8.

**Table 8**

| Roughening current divided by roughening speed | Example C surface roughness | Example C peel strength | Example C transmission loss | Comparative Example D surface rough-ness | Comparative Example D peel strength | Comparative Example D transmission loss |
|---|---|---|---|---|---|---|
| 2600 | 7.20 | 1.57 | 4.45 | 2.40 | 1.07 | 4.38 |
| 900 | 3.95 | 1.42 | 3.79 | 1.25 | 0.77 | 3.77 |
| 400 | 2.90 | 1.22 | 3.7 | 0.90 | 0.60 | 3.71 |
| 200 | 2.55 | 1.21 | 3.62 | 0.90 | 0.59 | 3.64 |

As clear from Table 8, almost no difference in transmission loss between the untreated copper foil of Example C and the untreated copper foil of Comparative Example D can be recognized even when changing the conditions of the roughening current divided by roughening speed. As described above, it is considered that the transmission loss depends on the roughening current divided by the roughening speed (current density and line speed). It is verified from the examples that both with the untreated foils C and D, when the roughening current and the roughening speed are set the same, there is no difference in the transmission loss.

On the other hand, for the peel strength, as shown in Table 8, the untreated copper foil of Comparative Example D cannot be used due to the decline of the peel strength when the roughening current divided by the roughening speed becomes small. However, the copper foil of Example C of the present invention has a high peel strength even when the roughening current divided by the roughening speed becomes small and further has a transmission loss characteristic that is equal to untreated copper foil D.

As described above, in Comparative Example D, a clear decline of the peel strength was observed due to the weakening of the roughening treating. In Example C of the present invention, a slight decline of the peel strength was observed due to the weakening of the roughening treating, but the peel strength was sufficient compared with Comparative Example D. Further, the transmission loss is almost the same as Comparative Example D. Therefore, copper foil with excellent transmission loss and further high peel strength and a method for producing the same are available according to the present invention. Needless to say, the copper foil produced in the present invention has a small surface roughness and high peel strength, so is suitable for copper foil for a printed circuit other than for high frequency applications as well.

### Example 2

### (1) Untreated Copper Foil-Making Conditions, Types of Surface Plating, and Amounts of Deposition (mg/dm²)

Untreated copper foils were produced having thicknesses of 35 µm according to the untreated copper foil-making conditions and solution compositions of Example C and Comparative Example D of Example 1 and treated on their surfaces as shown in Table 9.

**Table 9**

| Condition no. | Ni | Zn | Cr | Co | Si |
|---|---|---|---|---|---|
| 1 | 0.30 | 0.02 | 0.03 | 0 | 0.005 |
| 2 | 0.30 | 0.20 | 0.03 | 0.2 | 0.005 |
| 3 | 0.05 | 0.02 | 0.03 | 0 | 0.005 |
| 4 | 0.05 | 0.25 | 0.03 | 0 | 0.005 |
| 5 | 0.10 | 0.04 | 0.03 | 0 | 0.005 |
| 6 | 0.25 | 0.03 | 0.03 | 0.15 | 0.005 |
| 7 | 0.10 | 0.03 | 0.03 | 0 | 0 |

### (2) Performances

The Rz's of the copper foil treated on the surface at Table 9 and the peel strength to polyimide substrate are shown in Table 10.

**Table 10**

| Condition no. | Example C Rz after treatment (treated side) | Example C peel strength with polyimide substrate (kN/m) | Comparative Example D Rz after treatment (treated side) | Comparative Example D peel strength with polyimide substrate (kN/m) |
|---|---|---|---|---|
| 1 | 2.4 | 1.78 | 0.8 | 1.40 |
| 2 | 2.4 | 0.40 | 0.8 | 0.25 |
| 3 | 2.4 | 1.13 | 0.8 | 0.82 |
| 4 | 2.4 | 0.33 | 0.8 | 0.24 |
| 5 | 2.4 | 1.69 | 0.8 | 1.38 |
| 6 | 2.4 | 1.83 | 0.8 | 1.43 |
| 7 | 2.4 | 0.80 | 0.8 | 0.55 |

As shown in Table 10, by plating untreated copper foil by nickel, zinc, cobalt, or an alloy of the same or treating it by chromate or a coupling agent, the heat resistance, resistance to HCl, and stain proofing can be improved.

On the other hand, the transmission loss of copper foil treated on its surface by 3GHz is measured and shown in Table 11.

**Table 11**

| Condition no. | Untreated copper foil C | Untreated copper foil D |
|---|---|---|
| 1 | 3.58 | 3.60 |
| 2 | 3.56 | 3.60 |
| 3 | 3.56 | 3.55 |
| 4 | 3.57 | 3.58 |
| 5 | 3.60 | 3.58 |
| 6 | 3.60 | 3.58 |
| 7 | 3.58 | 3.57 |

As clear from Table 11, the transmission loss did not change so much in both Example C and Comparative Example D even when plating the untreated copper foil by nickel, zinc, cobalt, or an alloy of the same or treating it by chromate or a coupling agent.

Thus, by using untreated copper foil produced under the conditions of present invention, copper foil having a high peel strength can be provided without detracting from the transmission characteristic compared with copper foil produced by conventional methods.

Summarizing the effects of the invention, as described above, according to the present invention, there is the superior effect that a superior copper foil can be provided which is given a slightly higher surface roughness to make the peel strength to a resin substrate high without detracting from the high frequency characteristic. Therefore, it is very effective according to the applications in the case where a high peel strength is needed more than surface roughness and is a very suitable copper foil for high frequency applications.

While the invention has been described with reference to specific embodiments chosen for purpose of illustration, it should be apparent that numerous modifications could be made thereto by those skilled in the art without departing from the basic concept and scope of the invention.

## Claims

1. An electrodeposited copper foil wherein part of its surface comprises a rough surface having knob-like projections and a surface roughness of 2 to 4 µm.

2. An electrodeposited copper foil as set forth in claim 1, wherein said rough surface having said knob-like projections and said surface roughness of 2 to 4 µm is a surface of an untreated copper foil for bonding with a resin substrate and is further roughening treated by running a predetermined current through the foil for a predetermined time in an electroforming bath.

3. An electrodeposited copper foil as set forth in claim 2, wherein said electroforming bath is an acidic electroforming bath containing at least one of molybdenum, cobalt, nickel, iron, tungsten and arsenic.

4. An electrodeposited copper foil as set forth in claim 2 or 3, wherein said rough surface is further formed with a copper plating layer.

5. An electrodeposited copper foil as set forth in claim 2 or 3, wherein said rough surface is further formed with a copper plating layer and at least one layer of nickel plating, zinc plating, cobalt plating, plating of an alloy of the same and a chromate treatment layer on that, and according to need further formed with a coupling agent treatment layer.

6. An electrodeposited copper foil as set forth in claim 1, wherein said rough surface having said knob-like projections and said surface roughness of 2 to 4 µm is a surface of an untreated copper foil for bonding with a resin substrate and is further formed with a copper plating layer and at least one layer of nickel plating, zinc plating, cobalt plating, plating of an alloy of the same and a chromate treatment layer on that, and according to need further formed with a coupling agent treatment layer.

7. A method of producing an electrodeposited copper foil comprising electrolysis using an electrolyte containing copper as a main component and a compound having mercapto groups, at least one type of another organic compound, and chloride ions to form a copper foil wherein part of its surface comprises a rough surface having knob-like projections and a surface roughness of 2 to 4 µm.

8. A method of producing an electrodeposited copper foil as set forth in claim 7, wherein an electroforming bath for a roughening treatment is an acidic electroforming bath containing at least one of molybdenum, cobalt, nickel, iron, tungsten and arsenic.

9. A method of producing an electrodeposited copper foil comprising producing an electrodeposited copper foil having a matte side having a surface roughness of 2 to 4 µm using an electrolyte containing a compound having mercapto groups, at least one type of another organic compound, and chloride ions and roughening treating said matte side of said electrodeposited copper foil by running a predetermined current through it for a predetermined time in an electroforming bath.
